# EUROPEAN PATENT APPLICATION

(11) **EP 4 793 994 A1**
(43) Date of publication of application: **19.08.2026**
(21) Application number: 24877472.1
(22) Date of filing: 07.10.2024
(51) Int. Cl.: H01L 23/373, H01L 23/467, H01L 23/15, H05K 1/03

(54) **CERAMIC INSULATING BOARD**

(30) Priority: 12.10.2023 KR 20230135811
(71) Applicant: KCC Corporation, Seoul 06608 (KR)
(72) Inventor: KWAK, Man Suk, Wanju-gun, Jeonbuk-do 55317 (KR); KIM, Bo Kyeong, Jeonju-si, Jeonbuk-do 55145 (KR)
(74) Representative: Pfenning, Meinig & Partner mbB
(86) International application number: PCT/KR2024/015168
(87) International publication number: WO 2025/079934

(57) **Abstract**

A ceramic insulating board according to the present invention comprises: a ceramic substrate; a first metal layer installed on the upper surface of the ceramic substrate; a second metal layer installed on the lower surface of the ceramic substrate and partially disposed on the lower surface of the ceramic substrate; and a third metal layer installed below the second metal layer, wherein the second metal layer is disposed such that a portion of the lower surface of the ceramic substrate can be directly exposed to air.

## Description

### [Technical Field]

The present invention relates to a ceramic insulating board.

### [Background Art]

Ceramic insulating boards are commonly used in high-power inverters and converter power modules because the ceramic insulating boards exhibit low strain at high temperature and excellent insulation properties at high voltage. Ceramic insulating boards may be classified into direct copper bonding (DCB), active metal brazing (AMB), and the like according to a method of bonding copper.

Meanwhile, when a power module operates, high heat is generated in semiconductor devices, such a heat generation problem causes switching losses, which degrades the performance of the product, and in the case of silicon semiconductor devices, semiconductor properties may disappear at 150 °C or higher.

When a power module may be manufactured by attaching boards formed of various materials and when there are many interfaces between the materials, a thickness increases, making miniaturization difficult and reducing a heat transfer effect due to thermal resistance, and thus a technology for dissipating heat using the minimum number of boards is required.

For example, in Korean Laid-open Patent Publication No. 10-2018-0059778, a configuration in which a heat dissipation fin is provided on a corresponding board is disclosed. However, such a configuration has limitations in performance of heat transfer because heat is inevitably transferred to the heat dissipation fin through only conduction.

### [Description of Invention]

### [Technical Problem]

An object of the present invention is to provide a ceramic insulating board capable of effectively dissipating heat.

### [Technical Solution]

A ceramic insulating board according to the present invention includes: a ceramic substrate; a first metal layer installed on an upper surface of the ceramic substrate; a second metal layer installed on a lower surface of the ceramic substrate, wherein the second metal layer is partially disposed on the lower surface of the ceramic substrate; and a third metal layer installed below the second metal layer, wherein the second metal layer is disposed such that a portion of the lower surface of the ceramic substrate is directly exposed to air.

Further, the second metal layer may be formed such that air passes from any one point at edges of the lower surface of the ceramic substrate to another point at the edges of the lower surface of the ceramic substrate across an inner side of the lower surface of the ceramic substrate.

Further, the second metal layer may include a plurality of blocks arranged to be spaced apart from each other.

Further, a thickness of the second metal layer may be 1 to 2 times a thickness of the first metal layer.

Further, a distance between the blocks of the second metal layer may be 0.5 to 1.5 times a thickness of the second metal layer.

Further, a total area of the second metal layer may be 40 to 80% of an area of the third metal layer.

Further, the third metal layer may be formed to have an area corresponding to an outer contour of the entire second metal layer and may be integrally bonded to the entire second metal layer.

Further, a semiconductor chip may be designed to be mounted on an upper side of the first metal layer, and the second metal layer may be formed to have a region corresponding to a section for mounting the semiconductor chip, wherein the region may have a relatively greater area than other regions of the second metal layer or have an area corresponding to the semiconductor chip.

### [Advantageous Effects]

In a ceramic insulating board according to the present invention, by partially disposing a second metal layer on a lower surface of a ceramic substrate, in addition to heat transfer by conduction through the second metal layer and a third metal layer in a ceramic substrate, the lower surface of the ceramic substrate is directly exposed to air between adjacent blocks of the second metal layer, that is, air can pass between the adjacent blocks of the second metal layer, and thus the heat can be more rapidly and effectively transferred by convection resulting therefrom.

### [Description of Drawings]

FIG. 1 is a perspective view of a ceramic insulating board according to an embodiment of the present invention.
FIG. 2 is a view illustrating a state in which a first metal layer and a ceramic substrate in FIG. 1 have been removed.
FIG. 3 is a side view of the ceramic insulating board according to an embodiment of the present invention.
FIG. 4 is an enlarged view illustrating portion IV in FIG. 3.
FIG. 5 is a view illustrating a ceramic insulating board according to another embodiment of the present invention and corresponds to FIG. 2.
FIG. 6 is a view illustrating a ceramic insulating board according to still another embodiment of the present invention and corresponds to FIG. 2.

### [Modes of the Invention]

A ceramic insulating board 10 according to an embodiment of the present invention will be described in detail with reference to the drawings.

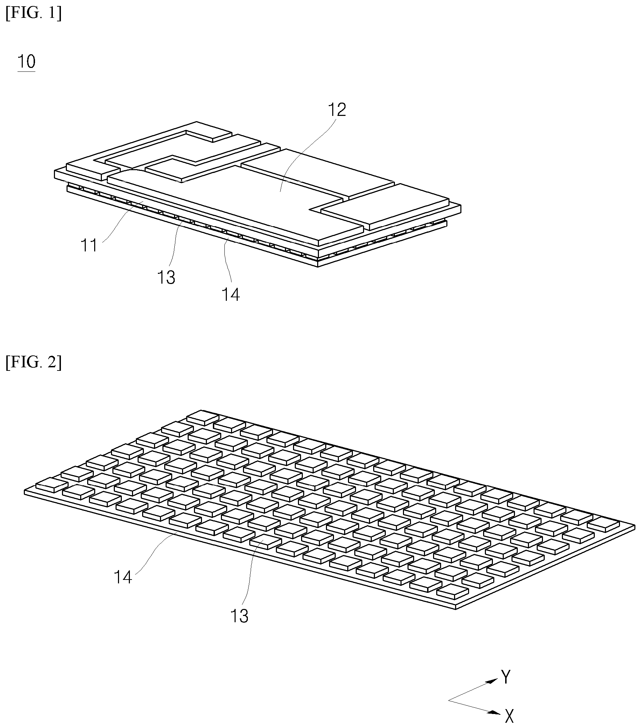

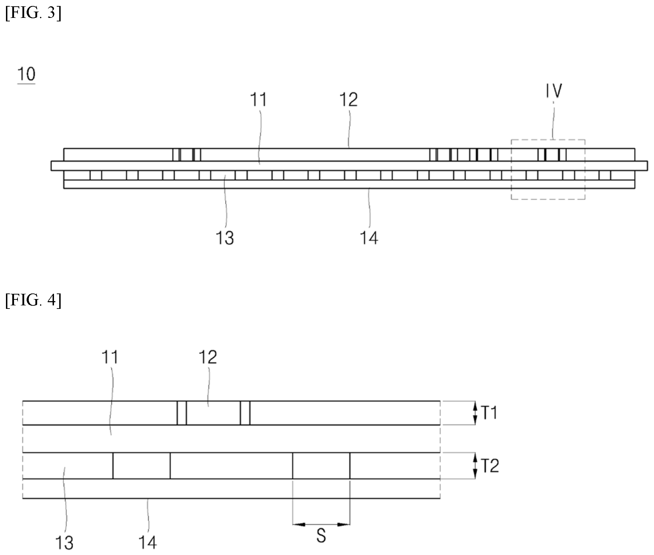

FIG. 1 is a perspective view of the ceramic insulating board 10 according to an embodiment of the present invention, and FIG. 2 is a view illustrating a state in which a first metal layer 12 and a ceramic substrate 11 in FIG. 1 have been removed. Further, FIG. 3 is a side view of the ceramic insulating board 10 according to an embodiment of the present invention, and FIG. 4 is an enlarged view illustrating portion IV in FIG. 3.

Referring to FIGS. 1 to 4, the ceramic insulating board 10 according to an embodiment of the present invention includes a ceramic substrate 11, a first metal layer 12, a second metal layer 13, and a third metal layer 14.

The ceramic substrate 11 is formed in a plate shape. In the drawings, although an example in which the ceramic substrate 11 is formed in a rectangular shape is illustrated, the ceramic substrate 11 may be formed in any of various shapes and sizes according to the application or requirements.

Further, the ceramic substrate 11 is formed of an insulating ceramic material. For example, the ceramic substrate 11 formed of alumina (Al₂O₃), aluminum nitride (AlN), zirconia (ZrO₂), silicon nitride (Si₃N₄), silicon carbide (SiC), etc., but the material thereof is not limited thereto.

The ceramic substrate 11 is provided such that the first metal layer 12 is installed on an upper surface of the ceramic substrate 11 and the second metal layer 13 is installed on a lower surface of the ceramic substrate 11.

The first metal layer 12 is installed on the upper surface of the ceramic substrate 11.

The first metal layer 12 is disposed in a specific pattern, and since the pattern may vary according to the application or requirements, the present invention does not specify the pattern in detail here.

The first metal layer 12 may be formed of pure copper or a copper alloy and bonded to the upper surface of the ceramic substrate 11 using a direct copper bonding (DCB) method. The DCB method is a method of forming an oxide film on copper and performing direct bonding by heating at 1,000 °C to 1,065 °C, and since this method itself is known, a detailed description thereof will be omitted.

Semiconductor devices or other devices (not illustrated) are installed and operated on an upper side of the first metal layer 12.

The second metal layer 13 is installed on the lower surface of the ceramic substrate 11.

The second metal layer 13 may be formed of pure copper or a copper alloy and bonded to the lower surface of the ceramic substrate 11 using a DCB method.

In particular, the second metal layer 13 does not cover the entire lower surface of the ceramic substrate 11 but is partially disposed on the lower surface of the ceramic substrate 11. In other words, the second metal layer 13 may be disposed such that a portion of the lower surface of the ceramic substrate 11 is directly exposed to air, thereby lowering a temperature of the ceramic substrate 11 and maintaining semiconductor properties thereof. More specifically, the second metal layer 13 is formed such that air may pass from any one point at edges of the lower surface of the ceramic substrate 11 to another point at the edges of the lower surface of the ceramic substrate 11 across an inner side of the lower surface of the ceramic substrate 11.

For example, the second metal layer 13 may include a plurality of blocks which are formed in a polygonal shape, such as a quadrangular shape, a triangular shape, a pentagonal shape, a hexagonal shape, etc., a circular shape, an elliptical shape, or the like and arranged on the same plane to be spaced apart from each other. These blocks may be formed, for example, by attaching one large copper plate for forming the second metal layer 13 to the lower surface of the ceramic substrate 11 and then forming the attached copper plate into a desired pattern by etching. In the drawings, an example in which the blocks of the second metal layer 13 are formed in a square shape and are arranged to be spaced an equal distance from each other in each of an X-axis direction and a Y-axis direction, forming a total of 112 blocks is illustrated. Therefore, the lower surface of the ceramic substrate 11 may be directly exposed to air between adjacent blocks of the second metal layer 13, and air may pass between the adjacent blocks of the second metal layer 13.

The third metal layer 14 is installed below the second metal layer 13.

The third metal layer 14 may be formed to have an area corresponding to an outer contour of the entire second metal layer 13 and bonded to the entire second metal layer 13. For example, the third metal layer 14 may be formed of pure copper or a copper alloy, like the second metal layer 13 and may be integrally bonded to the second metal layer 13 using a thermal fusion bonding method. Therefore, since there is no separate interface between the second metal layer 13 and the third metal layer 14, heat may be effectively transferred from the second metal layer 13 to the third metal layer 14.

A heat sink (not illustrated) may be installed on a lower side of the third metal layer 14 so that heat may be transferred to the heat sink.

The third metal layer 14 reinforces the ceramic insulating board 10 to prevent the ceramic substrate 11 from being bent due to a difference in thickness between the first metal layer 12 and the second metal layer 13 and increase a contact area with the heat sink. When the third metal layer 14 is not present on a lower side of the second metal layer 13 and there is a difference in thickness between the first metal layer 12 and the second metal layer 13, the ceramic substrate 11 may be bent upward or downward, and thus the product may be damaged.

According to the above-described configuration, in addition to the heat transfer by conduction through the second metal layer 13 and the third metal layer 14 in the ceramic substrate 11, the lower surface of the ceramic substrate 11 is directly exposed to air between adjacent blocks of the second metal layer 13, that is, air may pass between the adjacent blocks of the second metal layer 13, and thus the heat may be more rapidly and effectively transferred by convection resulting therefrom.

In order to more reliably achieve the above effect, the second metal layer 13 may be formed to satisfy the following conditions.

For example, a thickness T2 of the second metal layer 13 may be 1 to 2 times a thickness T1 of the first metal layer 12 and, preferably, 1 to 1.5 times.

By setting the thickness T2 of the second metal layer 13 to be at least 1 time the thickness T1 of the first metal layer 12, a sufficient space through which air passes may be secured on a lower side of the ceramic substrate 11.

On the other hand, when the thickness T2 of the second metal layer 13 is thin to less than one times the thickness T1 of the first metal layer 12, there is not enough space through which air passes, and thus heat transfer using convection may not be efficient, and when the thickness T2 of the second metal layer 13 is thick enough to exceed two times the thickness T1 of the first metal layer 12, the second metal layer 13 may expand excessively in volume due to thermal expansion during manufacturing or use, causing the ceramic substrate 11 to be bent inappropriately. Therefore, the above problem may be prevented by limiting the thickness T2 of the second metal layer 13 to less than or equal to two times the thickness T1 of the first metal layer 12 and, preferably, less than or equal to 1.5 times.

Further, a distance S between the blocks of the second metal layer 13 may be 0.5 to 1.5 times the thickness T2 of the second metal layer 13.

By setting the distance S between the blocks of the second metal layer 13 to be at least 0.5 times the thickness T2 of the second metal layer 13, a sufficient space through which air passes may be secured at the lower side of the ceramic substrate 11.

On the other hand, when the distance S between the blocks of the second metal layer 13 is small to less than 0.5 times the thickness T2 of the second metal layer 13, there is not enough space through which air passes at the lower side of the ceramic substrate 11, and thus heat transfer using convection may not be efficient, and when the distance S between the blocks of the second metal layer 13 is wide enough to exceed 1.5 times the thickness T2 of the second metal layer 13, the third metal layer 14 may come into contact with the ceramic substrate 11 due to thermal expansion at a high temperature when the third metal layer 14 is bonded to the second metal layer 13, and thus a sufficient space through which air passes may not be secured at the lower side of the ceramic substrate 11. Therefore, the above problem may be prevented by limiting the distance S between the blocks of the second metal layer 13 to less than or equal to 1.5 times the thickness T2 of the second metal layer 13.

Further, a total area of the second metal layer 13 (i.e., the sum of areas of the respective blocks) may range from 40 to 80% of an area of the third metal layer 14.

By setting the total area of the second metal layer 13 to be more than or equal to 40% the area of the third metal layer 14, the performance of heat transfer from the ceramic substrate 11 to the heat sink through the second metal layer 13 and the third metal layer 14 may be maintained at an appropriate level or higher, and by limiting the total area of the second metal layer 13 to less than or equal to 80% of the area of the third metal layer 14, a space through which air passes may be secured at an appropriate level or higher on the lower side of the ceramic substrate 11.

On the other hand, when the total area of the second metal layer 13 is set to be less than 40% of the area of the third metal layer 14, the effect of heat transfer by conduction through the third metal layer 14 may be reduced, and when the total area of the second metal layer 13 is set to be more than 80% of the area of the third metal layer 14, heat by convection may not be transferred smoothly as an empty space through which air may flow is reduced.

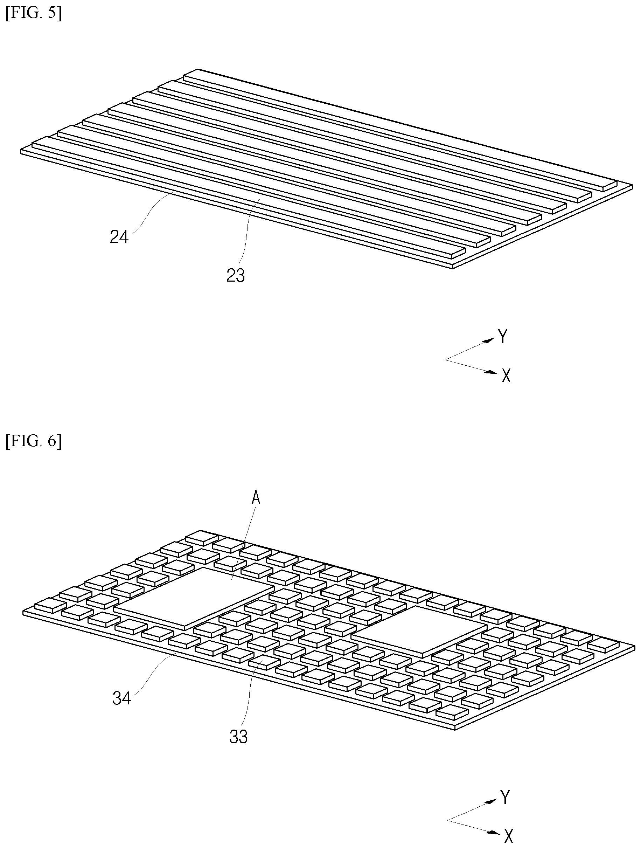

FIG. 5 is a view illustrating a ceramic insulating board according to another embodiment of the present invention and corresponds to FIG. 2.

The ceramic insulating board according to another embodiment of the present invention includes a ceramic substrate, a first metal layer, a second metal layer 23, and a third metal layer 24. However, since the ceramic substrate, the first metal layer, and the third metal layer 24 of the DCB board according to another embodiment of the present invention are substantially the same as the ceramic substrate 11, the first metal layer 12, and the third metal layer 14 of the DCB board 10 according to an embodiment of the present invention, a repetitive description thereof will be omitted, and hereinafter, the second metal layer 23 will be mainly described with reference to FIG. 5.

The second metal layer 23 may be installed on a lower surface of the ceramic substrate, be formed of pure copper or a copper alloy, and be bonded to the lower surface of the ceramic substrate using a DCB method. In particular, the second metal layer 23 does not cover the entire lower surface of the ceramic substrate but is partially disposed on the lower surface of the ceramic substrate. In other words, the second metal layer 23 may be disposed such that a portion of the lower surface of the ceramic substrate is directly exposed to air. More specifically, the second metal layer 23 is formed such that air may pass from any one point at edges of the lower surface of the ceramic substrate to another point at the edges of the lower surface of the ceramic substrate across an inner side of the lower surface of the ceramic substrate.

For example, the second metal layer 13 may include a plurality of blocks which are formed in a line shape and arranged on the same plane to be spaced apart from each other. In the drawing, an example in which the blocks of the second metal layer 23 are consecutively formed in a straight line in an X-axis direction between any one edge of the lower surface of the ceramic substrate and an edge facing the one edge and are arranged to be spaced an equal distance from each other in a Y-axis direction, forming a total of 7 blocks is illustrated. Therefore, the lower surface of the ceramic substrate may be directly exposed to air between adjacent blocks of the second metal layer 23, and air may pass between the adjacent blocks of the second metal layer 23.

However, as still another embodiment, blocks of a second metal layer may be formed in a diagonal direction between any one edge of a lower surface of a ceramic substrate and an edge adjacent thereto, may be formed intermittently, or may be formed in a curved shape or in a linear shape that is bent or curved at least once.

According to the above-described configuration, in addition to the heat transfer by conduction through the second metal layer 23 and the third metal layer 24 in the ceramic substrate, the lower surface of the ceramic substrate is directly exposed to air between adjacent blocks of the second metal layer 23, that is, air may pass between the adjacent blocks of the second metal layer 23, and thus the heat may be more rapidly and effectively transferred by convection resulting therefrom.

In order to more reliably achieve the above effect, the second metal layer 23 may be formed to satisfy the following conditions:
① a thickness of the second metal layer 23 may be 1 to 2 times a thickness of the first metal layer and, preferably, 1 to 1.5 times;
② a distance between the blocks of the second metal layer 23 may be 0.5 to 1.5 times a thickness of the second metal layer 23; and
③ a total area of the second metal layer 23 (i.e., the sum of areas of the respective blocks) may range from 40 to 80% of an area of the third metal layer 24, and
since its significance has been described above, a repetitive description thereof will be omitted.

FIG. 6 is a view illustrating a ceramic insulating board according to still another embodiment of the present invention and corresponds to FIG. 2.

The ceramic insulating board according to still another embodiment of the present invention includes a ceramic substrate, a first metal layer, a second metal layer 33, and a third metal layer 34. However, since the ceramic substrate, the first metal layer, and the third metal layer 34 of the DCB board according to still another embodiment of the present invention are substantially the same as the ceramic substrate 11, the first metal layer 12, and the third metal layer 14 of the DCB board 10 according to an embodiment of the present invention, a repetitive description thereof will be omitted, and hereinafter, the second metal layer 33 will be mainly described with reference to FIG. 6.

The second metal layer 33 may be installed on a lower surface of the ceramic substrate, be formed of pure copper or a copper alloy, and be bonded to the lower surface of the ceramic substrate using a DCB method. In particular, the second metal layer 33 does not cover the entire lower surface of the ceramic substrate but is partially disposed on the lower surface of the ceramic substrate. In other words, the second metal layer 33 may be disposed such that a portion of the lower surface of the ceramic substrate is directly exposed to air. More specifically, the second metal layer 33 is formed such that air may pass from any one point at edges of the lower surface of the ceramic substrate to another point at the edges of the lower surface of the ceramic substrate across an inner side of the lower surface of the ceramic substrate. Further, a semiconductor chip may be mounted on an upper side of the first metal layer, and the second metal layer 33 has a region A corresponding to a section for mounting a semiconductor chip (not illustrated).

An area of the region A corresponding to the section for mounting the semiconductor chip (not illustrated) is an area substantially corresponding to the semiconductor chip or is an area that is relatively greater than other regions. Therefore, by direct heat transfer by conduction through the region A corresponding to the section for mounting the semiconductor chip (not illustrated) and heat transfer by convection through regions corresponding to the remaining sections, the overall heat management effect can be improved.

The ceramic insulating board described above is merely one of ceramic insulating boards according to various embodiments of the present invention. The technical scope of the present invention is not limited to the above embodiments but includes all scopes that can be easily modified by those skilled in the art to which the present invention pertains, as described in the claims.

## Claims

1. A ceramic insulating board comprising:
a ceramic substrate;
a first metal layer installed on an upper surface of the ceramic substrate;
a second metal layer installed on a lower surface of the ceramic substrate, wherein the second metal layer is partially disposed on the lower surface of the ceramic substrate; and
a third metal layer installed below the second metal layer,
wherein the second metal layer is disposed such that a portion of the lower surface of the ceramic substrate is directly exposed to air.

2. The ceramic insulating board of claim 1, wherein the second metal layer is formed such that air passes from any one point at edges of the lower surface of the ceramic substrate to another point at the edges of the lower surface of the ceramic substrate across an inner side of the lower surface of the ceramic substrate.

3. The ceramic insulating board of claim 1, wherein the second metal layer includes a plurality of blocks arranged to be spaced apart from each other.

4. The ceramic insulating board of claim 3, wherein a thickness of the second metal layer is 1 to 2 times a thickness of the first metal layer.

5. The ceramic insulating board of claim 3, wherein a distance between the blocks of the second metal layer is 0.5 to 1.5 times a thickness of the second metal layer.

6. The ceramic insulating board of claim 3, wherein a total area of the second metal layer is 40 to 80% of an area of the third metal layer.

7. The ceramic insulating board of claim 3, wherein the third metal layer is formed to have an area corresponding to an outer contour of the entire second metal layer and is integrally bonded to the entire second metal layer.

8. The ceramic insulating board of claim 3, wherein a semiconductor chip is designed to be mounted on an upper side of the first metal layer, and
the second metal layer is formed to have a region corresponding to a section for mounting the semiconductor chip, wherein the region has a relatively greater area than other regions of the second metal layer or has an area corresponding to the semiconductor chip.
